# EUROPÄISCHE PATENTSCHRIFT

(11) **EP 4 161 214 B1**
(45) Veröffentlichungstag und Bekanntmachung des Hinweises auf die Patenterteilung: **07.01.2026**
(21) Anmeldenummer: 22196071.9
(22) Anmeldetag: 16.09.2022
(51) Int. Cl.: H05B 3/58, H05B 3/06, H05K 1/18, H05K 3/34, H01R 12/70

(54) **HEIZEINRICHTUNG UND VERFAHREN ZUR HERSTELLUNG EINER HEIZEINRICHTUNG**
HEATING DEVICE AND METHOD FOR PRODUCING A HEATING DEVICE
DISPOSITIF DE CHAUFFAGE ET PROCÉDÉ DE FABRICATION D'UN DISPOSITIF DE CHAUFFAGE

(30) Priorität: 01.10.2021 DE 102021211121
(43) Veröffentlichungstag der Anmeldung: 05.04.2023
(73) Patentinhaber: E.G.O. Elektro-Gerätebau GmbH, 75038 Oberderdingen (DE)
(72) Erfinder: Mandl, Matthias, 75015 Bretten (DE); Tafferner, Michael, 76316 Malsch (DE); Block, Volker, 75015 Bretten (DE); Schmieder, Manuel, 75038 Oberderdingen (DE); Köbrich, Holger, 76703 Kraichtal-Gochsheim (DE); Mühlnikel, Roland, 75015 Bretten (DE); Suß, Alfred, 75015 Bretten (DE); Eigl, Sebastian, 75015 Bretten (DE)
(74) Vertreter: Patentanwälte Ruff, Wilhelm, Beier, Dauster & Partner mbB

(56) Entgegenhaltungen:
- EP-A1- 3 096 585
- EP-A2- 2 176 869
- DE-A1- 10 304 906
- DE-A1- 102012 222 363
- DE-T2- 69 901 406
- KR-B1- 101 562 238
- US-A1- 2007 254 502

## Beschreibung

Die Erfindung betrifft eine Heizeinrichtung mit einem rohrförmigen Träger sowie ein Verfahren zur Herstellung einer solchen Heizeinrichtung.

Aus der EP 3096585 A1 ist eine Heizeinrichtung mit einem rohrförmigen Träger bekannt, auf der mehrere Heizleiter angeordnet sind. Da der rohrförmige Träger aus Metall bestehen kann, muss er auf seiner Außenseite eine Isolierschicht aufweisen, beispielsweise eine glasartige Isolierschicht. Dabei hat sich herausgestellt, dass beim Aufbringen der Isolierschicht mittels eines üblicherweise verwendeten Siebdruckverfahrens ein Überlappen des Drucks derart, dass eine in einem Arbeitsgang hergestellte Schicht sich überlappt und somit vollflächig ist, schwierig durchzuführen ist. Des Weiteren wird für einen elektrischen Anschluss an die Heizleiter eine Anschlussvorrichtung benötigt, die üblicherweise metallische Kontaktfüße aufweist, welche auf Kontaktfelder aufgelötet werden.

Aus der DE 102012222363 A1 ist eine Anschlussvorrichtung an eine solche Heizeinrichtung mit einem rohrförmigen Träger bekannt. Daraus ist zu ersehen, wie an der Anschlussvorrichtung Kontaktfüße angeordnet sind. Aus der DE 102012222364 A1 ist eine solche Anschlussvorrichtung mit Kontaktfüßen mit noch mehr Details bekannt.

Aus der KR 101 562 238 B1 ist eine weitere Heizeinrichtung entsprechend dem Oberbegriff des Anspruchs 1 bekannt mit einem Rohr, das eine Ummantelung aufweist. Die Ummantelung besteht dabei aus zwei Hälften, die sozusagen zusammengeklappt werden, um ein durchgängiges geschlossenes Rohr zu bilden. An der Außenseite sind Heizleiter angeordnet für die Heizfunktion.

In der EP 0 939 578 B1 ist dargestellt, wie ein Thermostat an einer Heizeinrichtung befestigt ist.

Aus der US 2007/254502 A1 ist eine weitere Heizeinrichtung bekannt mit elektrischen Anschlüssen, die flach ausgebildet ist. Eine Anschlussvorrichtung für einen elektrischen Anschluss der Heizeinrichtung ist am Rand angeordnet.

Aus der DE 103 04 906 A1 ist eine Anschlusskontaktfahne bekannt, die als SMT-Bauteil an einer flachen Leiterplatte bzw. entsprechenden Kontaktfeldern der Leiterplatte angelötet werden kann.

Aus der EP 2 176 869 A2 geht eine Heizeinrichtung mit einem Träger hervor, der Rohrform aufweisen kann. Ein elektrischer Anschluss erfolgt an Kontaktfelder außen an dem rohrförmigen Träger. Kontaktfelder für einen elektrischen Anschluss sollen selbst dann, wenn der rohrförmige Träger aus einem Blech geformt ist, und dazu aneinanderliegende Kanten miteinander verbunden werden, von einer Verbindungsnaht Abstand halten.

### Aufgabe und Lösung

Der Erfindung liegt die Aufgabe zugrunde, eine eingangs genannte Heizeinrichtung sowie ein Verfahren zu ihrer Herstellung zu schaffen, mit denen Probleme des Standes der Technik gelöst werden können und es insbesondere möglich ist, Aufbau und Betrieb der Heizeinrichtung sicher zu machen und gleichzeitig das Verfahren zu ihrer Herstellung praxistauglich zu gestalten.

Gelöst wird diese Aufgabe durch eine Heizeinrichtung mit den Merkmalen des Anspruchs 1 sowie durch ein Verfahren zu ihrer Herstellung mit den Merkmalen des Anspruchs 15. Vorteilhafte sowie bevorzugte Ausgestaltungen der Erfindung sind Gegenstand der weiteren Ansprüche und werden im Folgenden näher erläutert. Dabei werden manche der Merkmale nur für die Heizeinrichtung oder nur für das Verfahren zu ihrer Herstellung beschrieben. Sie sollen jedoch unabhängig davon sowohl für die Heizeinrichtung als auch für ein Verfahren selbstständig und unabhängig voneinander gelten können. Der Wortlaut der Ansprüche wird durch ausdrückliche Bezugnahme zum Inhalt der Beschreibung gemacht.

Die Heizeinrichtung weist einen rohrförmigen Träger mit einer Außenseite und mit einer Innenseite auf. Vorteilhaft ist der Träger ein kreisrundes Rohr. Ein Durchmesser kann größer sein als seine Länge, dies muss aber nicht so sein. Auf der Außenseite des Trägers ist eine Isolierschicht aufgebracht, vorteilhaft überdeckt sie diesen im Wesentlichen oder großteils, besonders vorteilhaft zwischen 50% und 100%. Auf der Isolierschicht sind Heizleiter, Kontaktfelder und Leiterbahnen vorgesehen bzw. unlösbar aufgebracht. Die Heizleiter bestehen aus einem üblichen Heizleitermaterial, vorteilhaft sind sie mittels eines Dickschichtverfahrens wie beispielsweise Siebdruck aufgebracht. Ihr elektrischer Anschluss kann mittels Leiterbahnen, die in den Kontaktfeldern enden, vorgesehen sein. Des Weiteren ist eine Anschlussvorrichtung für einen elektrischen Anschluss der Heizeinrichtung vorgesehen, die erfindungsgemäß mehrere metallische Kontaktfüße aufweist. Diese Kontaktfüße werden dann erfindungsgemäß an den Kontaktfeldern angeordnet, befestigt, insbesondere angelötet, oder angepresst. So haltern sie die Anschlussvorrichtung mechanisch und schließen sie auch elektrisch an. Die metallischen Kontaktfüße können in Anschlusskontakten, insbesondere Steckkontaktfahnen oder Steckkontaktstiften, in einem Gehäuse der Anschlussvorrichtung enden, so dass ein entsprechender Anschlussstecker daran angesteckt oder aufgesteckt werden kann. Üblicherweise sind die Kontaktfüße bzw. die entsprechenden Metallteile an einer Unterseite der Anschlussvorrichtung bzw. ihres Gehäuses eingesteckt, so dass sie nach oben gehalten sind. Dadurch liegen sie an der Unterseite offen, also zur Außenseite des Trägers hin.

Erfindungsgemäß ist zwischen der Anschlussvorrichtung und/oder deren Kontaktfüßen einerseits und der Außenseite des Trägers andererseits eine elektrische Zusatz-Isolierung angeordnet bzw. vorgesehen. Selbst wenn die Anschlussvorrichtung und somit auch die Kontaktfüße ein Stück oberhalb der Außenseite bzw. oberhalb des Trägers verlaufen, beispielsweise mit einem Abstand von mindestens 0,3 mm oder 1 mm, kann so eine nochmals bessere elektrische Isolierung erfolgen. Dies erhöht die Sicherheit der elektrischen Heizeinrichtung. Des Weiteren kann so möglicherweise ein Abstand zwischen der Außenseite des Trägers und der Anschlussvorrichtung bzw. den Kontaktfüßen reduziert werden, wodurch möglicherweise die Heizeinrichtung einfacher hergestellt werden kann, weil ein Herstellungsverfahren nicht so präzise und/oder aufwändig durchgeführt werden muss. Für die Ausgestaltung dieser elektrischen Zusatz-Isolierung gibt es mehrere Möglichkeiten, die im Folgenden jeweils noch einzeln erläutert werden.

In einer ersten vorteilhaften Ausgestaltung der Erfindung ist die elektrische Zusatz-Isolierung fest mit dem Träger verbunden oder ist fest an dem Träger angeordnet. Dies weist den Vorteil auf, dass sie nicht verloren gehen kann oder nicht in ihrer Position verändert werden kann, beispielsweise wenn die Anschlussvorrichtung befestigt wird. So ist die elektrische Isolierungs-Wirkung sichergestellt.

Erfindungsgemäß ist vorgesehen, dass der Träger eine Schweißnaht oder eine Verbindungsnaht aufweist, welche in seiner Längsrichtung und auch quer zur Umfangsrichtung verläuft. Eine solche Schweißnaht oder Verbindungsnaht kann dadurch entstehen, dass das Rohr aus einem ursprünglich flachen Blech hergestellt ist, welches zu einer Rohrform gebogen wird, wobei dann die beiden Endkanten aneinander anliegen und miteinander verbunden bzw. verschweißt werden. Eine solche Schweißnaht oder Verbindungsnaht verläuft üblicherweise in Längsrichtung des Trägers und quer zur Umfangsrichtung, also parallel zu einer Mittellängsachse des Rohrs. Erfindungsgemäß wird die Anschlussvorrichtung über der Schweißnaht angeordnet und übergreift diese, wobei die Anschlussvorrichtung einen Abstand zu der Schweißnaht aufweist. Ein solcher Abstand kann 0,3 mm bis 5 mm betragen. Es ist möglich, die Schweißnaht oder Verbindungsnaht nach ihrer Herstellung zumindest an der Außenseite des Trägers etwas zu glätten, beispielsweise durch Walzen oder Schleifen. Dennoch kann nicht immer sichergestellt werden, dass die Schweißnaht nicht ein Stück über die ansonsten kontinuierliche abgerundete Oberfläche bzw. Außenseite des Trägers übersteht. Deswegen ist es im Bereich der Schweißnaht üblicherweise schwierig, eine präzise bzw. genau vorgebbare Beschichtung der Außenseite des Trägers vorzunehmen, beispielsweise mit einem vorgenannten Siebdruckverfahren.

In bevorzugter Ausgestaltung der Erfindung sind demzufolge Heizleiter, Kontaktfelder und Leiterbahnen ausschließlich neben der Schweißnaht bzw. Verbindungsnaht angeordnet. Sie überdecken diese nicht, so dass sich vorgenannte Probleme bezüglich einer exakten Beschichtung nicht ergeben. Besonders vorteilhaft weisen sie einen Abstand von mindestens 1 mm zu der Verbindungsnaht bzw. einem Rand der Schweißnaht auf, insbesondere mindestens 5 mm. So kann vorteilhaft vorgesehen sein, dass die Kontaktfelder mit am nächsten zu der Schweißnaht angeordnet sind, und zwar auf beiden Seiten. Dann kann die Anschlussvorrichtung über der Schweißnaht verlaufen bzw. angeordnet sein. Da sehr nahe an der Anschlussvorrichtung und insbesondere darunter üblicherweise keine Heizleiter verlaufen sollten, kann so der Bereich nahe der Schweißnaht gut für die Anschlussvorrichtung genutzt werden.

Gemäß einer ersten Ausgestaltungsmöglichkeit der ersten grundsätzlichen Ausgestaltung der Erfindung wird die elektrische Zusatz-Isolierung von der Isolierschicht bzw. von einem Bereich der Isolierschicht gebildet. Diese Isolierschicht verläuft also zumindest teilweise über die Schweißnaht, vorteilhaft über einen wesentlichen Bereich ihrer Länge hinweg oder zumindest in einem Bereich derart, dass sie zwischen der Anschlussvorrichtung und der Außenseite des Trägers verläuft, bevorzugt mit einem Überstand von 1 mm bis 10 mm. Wird die Isolierschicht mit einem vorteilhaften Dickschichtverfahren wie Siebdruck aufgebracht, so stört die Schweißnaht erheblich weniger als im Fall der vorgenannten Heizleiter, Kontaktfelder und Leiterbahnen, da diese mit einer präzisen Breite und präzisen Dicke aufgebracht werden müssen. Dickenvariationen sind bei der Isolierschicht nicht sehr störend, solange sie in ausreichendem Maße bzw. mit ausreichender Dicke vorhanden ist. Da sie flächig bzw. großflächig aufgebracht wird, ist auch nicht auf eine seitliche Begrenzung oder Ausbreitung zu achten.

In weiterer Ausgestaltung kann vorgesehen sein, dass die elektrische Isolierschicht auf der Außenseite des Trägers mehrere Einzel-Isolierschichten aufweist bzw. aus mehreren Einzel-Isolierschichten gebildet ist. Sie liegen also schichtartig aufeinander, so dass sich ihre jeweilige Einzel-Dicke zu einer gesamten Dicke addiert. Dies können vorteilhaft zwei bis fünf oder zwei bis drei Einzel-Isolierschichten sein. Direkt zwischen der Außenseite des Trägers und der Anschlussvorrichtung ist mindestens eine Einzel-Isolierschicht als elektrische Zusatz-Isolierung vorgesehen. Dabei kann sie die vorgenannte Schweißnaht überdecken oder über dieser aufgebracht sein. In bevorzugter Ausgestaltung kann direkt zwischen der Außenseite des Trägers und der Anschlussvorrichtung mindestens eine Einzel-Isolierschicht weniger vorgesehen sein als insgesamt Einzel-Isolierschichten aufeinander vorgesehen sind, insbesondere unter den Heizleitern. Unter der Anschlussvorrichtung kann genau eine Einzel-Isolierschicht weniger vorgesehen sein als insgesamt. Dies wird aber immer noch als ausreichende elektrische Isolierung der Außenseite des Trägers gegenüber der Anschlussvorrichtung angesehen, da die Anschlussvorrichtung ja anders als die Heizleiter, Leiterbahnen und Kontaktfelder nicht direkt auf der Einzel-Isolierschicht aufliegt, sondern mit einem gewissen Abstand darüber verläuft wie vorgenannt. Des Weiteren ist es durch diese Ausgestaltung möglich, die Einzel-Isolierschichten nicht umlaufend geschlossen auszubilden bzw. vorzusehen. So können sie jeweils an ihren entlang der Umfangsrichtung weisenden Enden einen Abstand zueinander aufweisen bzw. die zwei gegenüberliegenden Enden einer Einzel-Isolierschicht können einen Abstand zwischen 1 mm und 30 mm zueinander aufweisen und so einen freien Abstands-Bereich aufweisen bzw. bilden. Dadurch kann das vorgenannte Problem vermieden werden, dass bei einer Aufbringung beispielsweise im Siebdruckverfahren keine Überlappung erfolgen kann oder erfolgen sollte. Dann würde das Sieb nämlich wieder in der frisch aufgebrachten Dickschichtpaste liegen und das Resultat wäre ein sehr unsauberer Siebdruck und somit eine sehr unsauber aufgebrachte Einzel-Isolierschicht. Dadurch könnte sogar deren mögliche vollflächige Ausbildung negativ beeinträchtigt werden, was auf alle Fälle zu vermeiden ist.

In weiterer bevorzugter Ausgestaltung kann vorgesehen sein, dass mindestens zwei Einzel-Isolierschichten aufeinanderliegen, um insgesamt die Isolierschicht zu bilden. Ihre jeweils in dieselbe Umfangsrichtung weisenden Enden überlappen sich dabei derart versetzt oder sind derart versetzt zueinander angeordnet, dass sich der Abstand zum anderen Ende derselben Schicht, also somit sozusagen die Lücke bzw. der Abstandsbereich in jeder der Einzel-Isolierschichten, nicht überdecken oder überlappen, sondern versetzt zueinander sind. Dies bedeutet, dass immer mindestens eine der beiden Einzel-Isolierschichten die Außenseite des Trägers bedeckt. Vorteilhaft sind die Abstände oder Abstandsbereiche zwischen zwei Enden derselben Einzel-Isolierschicht bzw. die entsprechende Lücke nicht oder nicht viel mehr als notwendig zueinander versetzt, so dass bei den mindestens zwei Einzel-Isolierschichten diese Bereiche mit einer verringerten gesamten Dicke der Isolierschicht in einem begrenzten und bevorzugt möglichst schmalen Bereich liegen. So können zwei solcher Lücken oder Abstandsbereiche von zwei übereinander verlaufenden Einzel-Isolierschichten beispielsweise nur um 1 mm bis 5 mm seitlich zueinander versetzt bzw. beabstandet sein.

Es können auch drei direkt aufeinanderliegende Einzel-Isolierschichten vorgesehen sein. Die beiden Enden der untersten Einzel-Isolierschichten können dabei unter den beiden Enden der obersten Einzel-Isolierschicht liegen, so dass sich diese Enden jeweils überdecken. Somit überdecken sich auch die jeweiligen Abstände bzw. Abstandsbereiche zwischen den beiden Enden. Die beiden Enden der dazwischenliegenden mittleren Einzel-Isolierschicht sind versetzt angeordnet, so dass ein Abstand zwischen diesen beiden Enden von einem durchgehenden Bereich der untersten Einzel-Isolierschicht und einem durchgehenden Bereich der obersten Einzel-Isolierschicht überdeckt ist. So kann insgesamt erreicht werden, dass die Außenseite des Trägers beinahe überall von zwei oder von drei Einzel-Isolierschichten bedeckt ist. Lediglich in einem Bereich mit Streifenform und in einer Breite entsprechend dem Abstand zwischen den beiden Enden ist dann nur eine einzige Einzel-Isolierschicht vorgesehen. In diesem Bereich kann aber die vorgenannte Schweißnaht verlaufen bzw. dieser Bereich kann die vorgenannte Schweißnaht überdecken. Im Bereich der Schweißnaht kann möglicherweise sogar vorgesehen sein, dass zwei Einzel-Isolierschichten darüber verlaufen bzw. sie bedecken.

Es kann vorgesehen sein, dass nach dem Aufbringen der Heizleiter, Kontaktfelder und Leiterbahnen auf die Isolierschicht eine nochmals weitere Überdeckschicht auf den Träger aufgebracht wird bzw. den Schichtaufbau bedeckt, insbesondere als Schutzschicht. Mindestens die Kontaktfelder sollten frei bleiben. Da auch diese Überdeckschicht vorteilhaft im Siebdruckverfahren aufgebracht wird, sollte sie ähnlich wie die Einzel-Isolierschichten nicht vollflächig vorgesehen sein, also mit sich überlappenden Enden. Vielmehr sollten die Enden auch einen Abstand zueinander aufweisen. Somit ähnelt diese Abdeckschicht den vorgenannten Einzel-Isolierschichten, und es kann eine entsprechende Überlappung der Abstände zwischen ihren Enden wie zuvor beschrieben vorgesehen sein. So kann bevorzugt vorgesehen sein, dass die Überdeckschicht zumindest dort vorgesehen ist, wo die bislang geringste Schichtdicke in der Isolierschicht vorgesehen ist. Der Abstand zwischen den beiden Enden der Überdeckschicht sollte dann über einem Abstand zwischen zwei Enden einer Einzel-Isolierschicht liegen, aber nicht dort, wo die geringste Dicke der gesamten Isolierschicht vorgesehen ist.

Gemäß einer zweiten Ausgestaltungsmöglichkeit der ersten grundsätzlichen Ausgestaltung der Erfindung wird die elektrische Isolierung durch eine elektrisch isolierende Abdeckschicht gebildet, welche als Lack, als Paste oder als Kleber unterhalb der Anschlussvorrichtung vorgesehen ist. Diese Abdeckschicht ist dann unterschiedlich von der Isolierschicht ausgebildet, insbesondere auch unterschiedlich von einer vorgenannten Überdeckschicht. Grundsätzlich kann die Abdeckschicht auf vielfältige Art und Weise aufgebracht werden, beispielsweise durch Sprühen, Dispensern, Drucken, Kleben odgl.. Diese Abdeckschicht ist dann nicht vollflächig auf der Außenseite bzw. auf dem Träger vorgesehen, sondern nur im Bereich der Anschlussvorrichtung. Sie sollte mindestens so groß sein wie die vertikale Projektion der Anschlussvorrichtung auf dem Träger. Insbesondere kann sie etwas größer sein, vorteilhaft zwischen 5 % und 50 % oder zwischen 1 mm und 10 mm in einer Richtung oder in beiden Richtungen über diese Projektion überlappen bzw. unter der Anschlussvorrichtung hervorstehen.

Gemäß einer zweiten grundsätzlichen Ausgestaltung der Erfindung ist die elektrische Isolierung ein starres Isolationsteil oder zumindest ein eigenständiges Teil, welches nicht außen am Träger befestigt ist wie beispielsweise eine der vorgenannten Schichten oder Beschichtungen. Dies ermöglicht es zum einen, die elektrische Isolierung unabhängig von dem Träger und seinen Schichten selbst herzustellen. Zum anderen kann ein solches starres oder eigenständiges Isolationsteil auf unterschiedliche und unabhängige Art und Weise hergestellt sein und entweder an dem Träger oder vorteilhaft an der Anschlussvorrichtung selbst befestigt sein. Eine Möglichkeit ist es, das Isolationsteil an der Unterseite der Anschlussvorrichtung zu befestigen. Dann kann zwar weiterhin vorgesehen sein, dass die Kontaktfüße von unten in die Anschlussvorrichtung eingebracht werden, beispielsweise eingesteckt werden. Damit sie aber nicht nach unten die Gefahr eines Kurzschlusses odgl. bewirken, sind sie mittels des daran befestigten Isolationsteils nach unten bedeckt oder isoliert. Lediglich der Bereich der Kontaktfüße, der seitlich von der Anschlussvorrichtung abgeht und ohnehin im Wesentlichen oder vollständig über einem darunter befindlichen Kontaktfeld verläuft, weil er auch mit diesem verbunden bzw. verlötet ist, ist dann frei. Er wird nicht von dem Isolationsteil überdeckt. Dabei kann das Isolationsteil in der Projektion so groß sein wie die Anschlussvorrichtung bzw. nicht seitlich nach außen über diese überstehen.

Eine Befestigung eines solchen Isolationsteils an der Anschlussvorrichtung kann vorteilhaft erfolgen, wenn die Anschlussvorrichtung noch nicht an dem Träger bzw. mit ihren Kontaktfüßen an den Kontaktfeldern befestigt ist. Bevorzugt kann dies ein Schritt sein, insbesondere ein letzter Schritt, bei der Herstellung der Anschlussvorrichtung selbst sein, insbesondere nachdem die Kontaktfüße in die Anschlussvorrichtung oder in ein Gehäuse der Anschlussvorrichtung eingebracht worden sind. Die Befestigung des Isolationsteils an der Unterseite der Anschlussvorrichtung kann durch Verkleben hergestellt sein, alternativ durch Verpressen, Verklemmen, Verrasten odgl..

Allgemein kann vorteilhaft vorgesehen sein, ähnlich wie es vorstehend beschrieben worden ist, dass die metallischen Kontaktfüße unten oder im Bereich der Unterseite der Anschlussvorrichtung von dieser seitlich abstehen oder über ihre vertikale Projektion nach außen überstehen. Mit diesen Bereichen können sie an die Kontaktfelder angelegt und festgelötet sein. Die erfindungsgemäße elektrische Isolierung sollte also zwischen den Kontaktfüßen einerseits und der Außenseite des Trägers andererseits vorgesehen sein, und zwar unterhalb der Anschlussvorrichtung. An den außen abstehenden Enden der Kontaktfüße sollte natürlich keine elektrische Isolierung vorhanden sein, da hier die Kontaktfüße ja an die freiliegenden Kontaktfelder angelötet werden sollen. Des Weiteren kann vorteilhaft vorgesehen sein, dass die Außenseite des Trägers dort ohne Isolierschicht ausgebildet ist oder nicht mit vollständiger Isolierschicht, wo die elektrische Isolierung verläuft. Dies ist insbesondere im Fall eines vorgenannten starren Isolationsteils, das unabhängig vom Träger ist, von Vorteil.

Somit kann vorgesehen sein, dass ein starres Isolationsteil separat vom Träger hergestellt wird, insbesondere an der Anschlussvorrichtung befestigt wird, bevor diese an den Träger angebracht wird. Eine Einzel-Isolierschicht, mehrere Einzel-Isolierschichten oder eine vorgenannte Abdeckschicht, die sich von den Einzel-Isolierschichten oder einer Isolierschicht unterscheidet, wird dagegen auf den Träger aufgebracht und ist somit unlösbar mit diesem verbunden. Erst danach wird die Anschlussvorrichtung am Träger befestigt.

Die Unterteilung der Anmeldung in einzelne Abschnitte sowie Zwischen-Überschriften beschränkt die unter diesen gemachten Aussagen nicht in ihrer Allgemeingültigkeit.

### Kurzbeschreibung der Zeichnungen

- Fig. 1: eine Schrägansicht auf eine erfindungsgemäße Heizeinrichtung im Bereich einer Schweißnaht, mit der sie zu einem Rohr geformt ist,
- Fig. 2: eine Draufsicht auf die Heizeinrichtung aus Fig. 1 mit einer daran befestigten Anschlussvorrichtung,
- Fig. 3: eine Schnittdarstellung durch einen Schichtaufbau des Trägers an sich samt Isolationsschichten darauf,
- Fig. 4: der Schichtaufbau entsprechend Fig. 3 auseinandergezogen entlang der Längsrichtung des Trägers,
- Fig. 5: eine Vergrößerung auf einen Bereich der Außenseite des Trägers mit Schweißnaht und mehreren unterschiedlich überlappenden Isolationsschichten sowie Kontaktfeldern,
- Fig. 6: eine Draufsicht auf die Heizeinrichtung aus Fig. 2 und
- Fig. 7: eine Schrägansicht auf die Anschlussvorrichtung von unten mit an den Seiten überstehenden Kontaktfüßen und einem Unterseitendeckel zur Abdeckung.

### Detaillierte Beschreibung der Ausführungsbeispiele

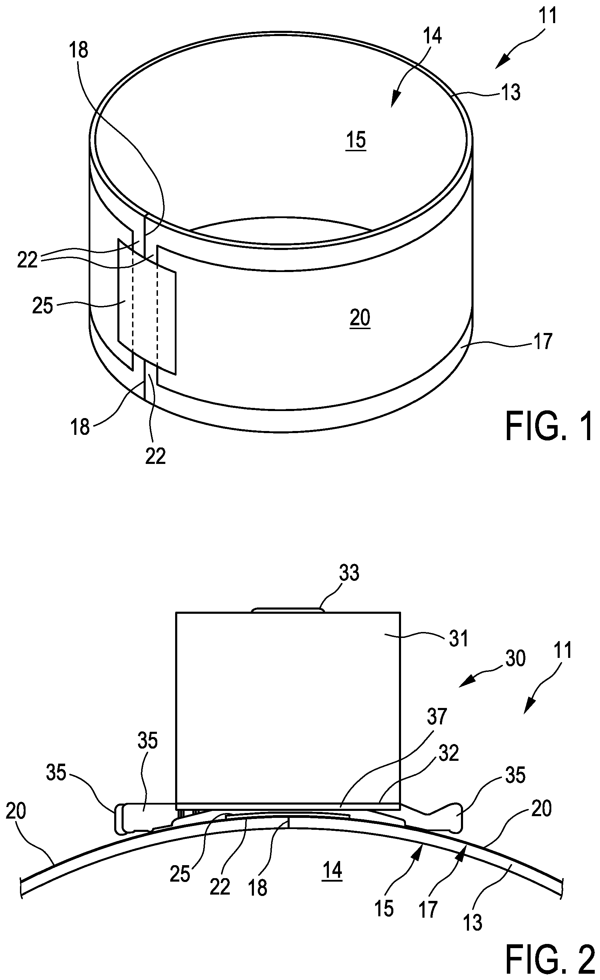

In der Fig. 1 ist eine erfindungsgemäße Heizeinrichtung 11 in Rohrform dargestellt mit einem rohrförmigen Träger 13. Der rohrförmige Träger 13 schließt einen entsprechenden Innenraum 14 ein. Er weist eine Innenseite 15 und eine Außenseite 17 auf. Der Träger 13 kann, wie eingangs erläutert, aus einem flachen Stahlblech durch Rundbiegen hergestellt sein und an den Enden mittels einer Schweißnaht 18 verbunden sein. Die Schweißnaht 18 kann nach Herstellung bearbeitet sein an der Innenseite und/oder an der Außenseite. Dies kann durch Bürsten, Schleifen oder aber durch Walzen, also durch starken Druck, erfolgen. Die Heizeinrichtung 11 kann beispielsweise eine Heizeinrichtung für eine Pumpe entsprechend der DE 102011079510 A1 sein. Im Innenraum 14 befindet sich dann Wasser, das von der Heizeinrichtung 11 erhitzt wird.

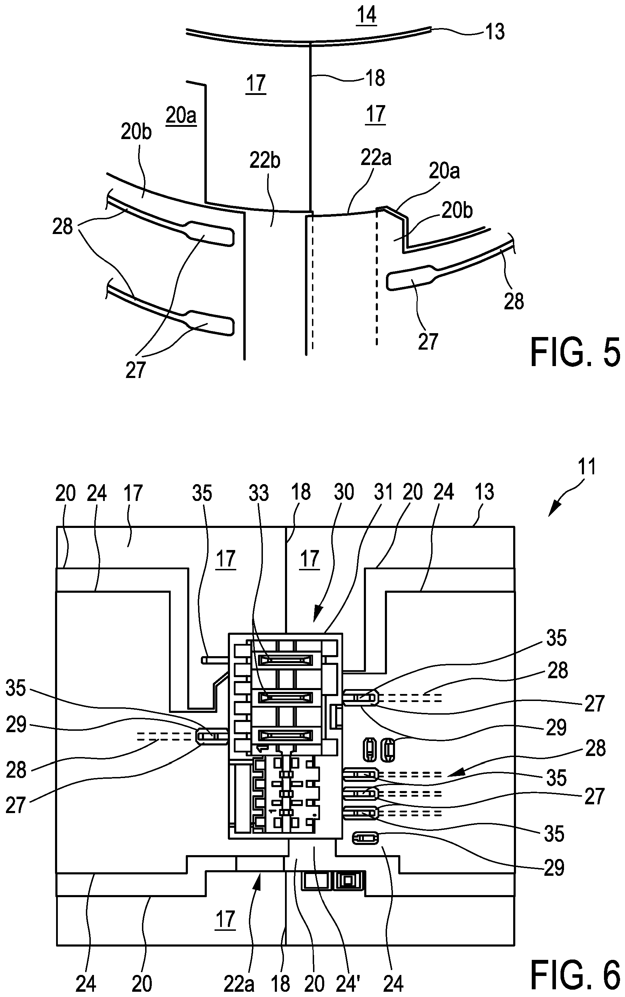

Die Heizeinrichtung 11 weist an der Außenseite 17 Heizleiter auf, die hier nicht näher dargestellt sind, die aber aus dem Stand der Technik bekannt sind. Da diese Heizleiter nicht direkt auf den metallischen Träger 13 aufgebracht werden können, ist eine Isolationsschicht 20 notwendig, die hier dargestellt ist. Die Isolationsschicht 20 weist einen Abstand zur Oberkante und zur Unterkante des Trägers 13 auf, dies kann aber unterschiedlich ausgebildet sein. Des Weiteren weisen die zueinander zeigenden Enden der Isolationsschicht 20 einen freien Abstandsbereich 22 dazwischen auf, dessen Breite beispielsweise etwa 3% bis 10% des Durchmessers des Trägers 13 betragen kann. Dieser freie Abstandsbereich 22 ist im Wesentlichen herstellungsbedingt. Wenn nämlich die Isolationsschicht 20 mittels Siebdruck hergestellt ist, wie es vorstehend als vorteilhaft erläutert worden ist, kann sie nicht überlappend oder vollständig umlaufend geschlossen sein bei gewünschtem hochqualitativem Druckergebnis. Da zusätzlich die Schweißnaht 18 etwas schwerer zu bedrucken ist als der Rest der Außenseite 17 des Trägers 13, ist der freie Abstandsbereich 22 um diese herum vorgesehen. Da nun an dieser Stelle eine Anschlussvorrichtung angebracht werden soll, wie dies in der nachfolgenden Fig. 2 und 6 zu sehen ist, und von der Anschlussvorrichtung metallische Kontaktfüße abstehen, ist es nicht zulässig, die metallische und freie Außenseite 17 ohne Isolationsschicht 20 zu belassen.

Aus den vorgenannten Gründen ist im Bereich des freien Abstandsbereichs 22 eine Abdeckschicht 25 als eine grundsätzliche Ausgestaltungsmöglichkeit vorgesehen. Diese kann nach Aushärten der Isolationsschicht 20 aufgebracht werden, beispielsweise durch Siebdruck, alternativ durch andere Verfahren. In einer nochmals weiteren Alternative kann sie als eine Art Klebeband oder als angeformtes Teil ausgebildet und am Träger 13 dauerhaft und temperaturbeständig befestigt werden, beispielsweise angeklebt. Die Abdeckschicht 25 kann aus unterschiedlichen geeigneten Materialien bestehen, beispielsweise auch aus entsprechend temperaturbeständigem Kunststoff oder Silikon. Wird sie als Schicht in einem Beschichtungsverfahren aufgebracht, beispielsweise Dickschichtverfahren mittels Siebdruck, so kann sie eine an sich übliche Schicht aus Glas odgl. bzw. glashaltig sein. Die Abdeckschicht 25 überdeckt den freien Abstandsbereich 22 und somit die metallische Außenseite 17 des Trägers 13 zuverlässig, so dass entsprechend Fig. 2 problemlos eine Anschlussvorrichtung befestigt werden kann ohne Gefahr eines Kurzschlusses.

In der Fig. 2 ist die genannte Draufsicht von oben in Vergrößerung dargestellt. Die Anschlussvorrichtung 30 weist ein Anschlussgehäuse 31 auf, von dem der oberste Teil einer abstehenden Steckfahne 33 zu sehen ist. Hierzu wird auch auf die Fig. 6 verwiesen. Unten an einer Unterseite stehen aus der Anschlussvorrichtung 30 bzw. aus dem Anschlussgehäuse 31 nach links und nach rechts Kontaktfüße 35 heraus, die an Kontaktfelder angelötet werden können, alternativ auch nur angepresst werden können. Dann reicht eine einzige feste Löt- oder Schweißverbindung an den Träger 13, beispielsweise an einem Masseanschluss. Derartige Kontaktfelder 27, die in Leiterbahnen 28 übergehen, sind beispielhaft in der Fig. 5 dargestellt. Dies wird nachfolgend noch näher erläutert.

Wie aus der Fig. 2 zu ersehen ist, ist ein freier Abstandsbereich 22 der Isolationsschicht 20 von der Abdeckschicht 25 mit ausreichender Überlappung überdeckt. Somit ist eine ausreichende Isolation des Trägers 13 gegenüber der Anschlussvorrichtung 30 gegeben. Die Abdeckschicht 25 bildet in dieser grundsätzlichen Ausgestaltung der Erfindung also die Zusatz-Isolierung.

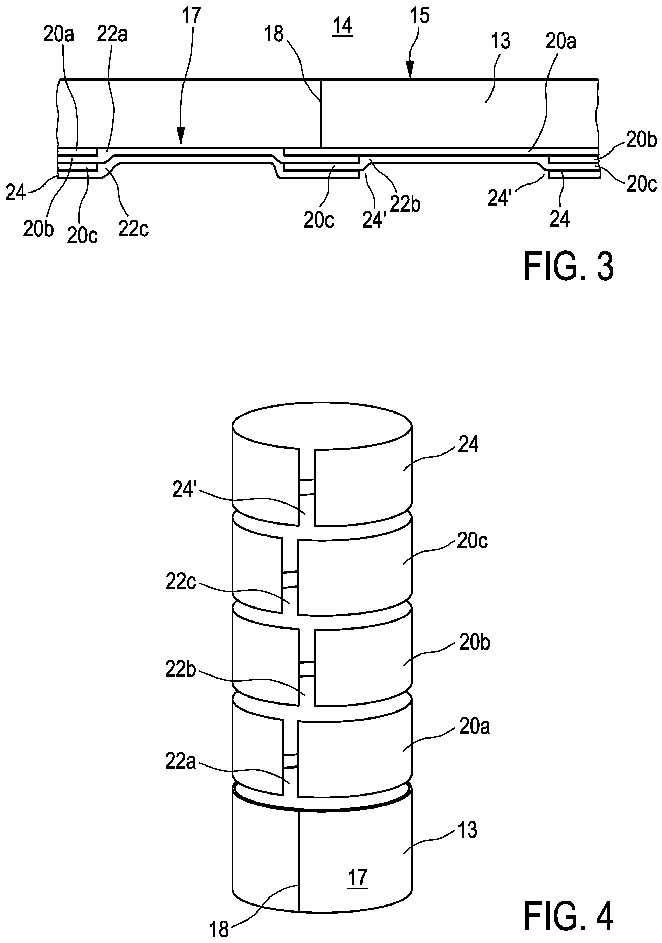

Eine weitere grundsätzliche Ausgestaltungsmöglichkeit für eine Zusatz-Isolierung ist in den Fig. 3 und 4 dargestellt. Die starke Vergrößerung der Schnittdarstellung der Fig. 3 zeigt den Träger 13 mit der Schweißnaht 18 samt Innenseite 15 und Außenseite 17. Auf die Außenseite 17 ist eine erste Einzel-Isolierschicht 20a aufgebracht. Sie weist einen freien Abstandsbereich 22a auf, der links von der Schweißnaht 18 liegt. Der rechte Endbereich der Einzel-Isolierschicht 20a überdeckt hier also die Schweißnaht 18.

Auf die Einzel-Isolierschicht 20a ist eine weitere Einzel-Isolierschicht 20b aufgebracht, grundsätzlich aus demselben Material, im selben Verfahren und mit derselben Dicke. Ein freier Abstandsbereich 22b liegt rechts von der Schweißnaht 18 und somit überdeckt er sich nicht mit dem freien Abstandsbereich 22a der darunterliegenden Einzel-Isolierschicht 20a. Darauf ist eine weitere Einzel-Isolierschicht 20c aufgebracht, deren freier Abstandsbereich 22c wiederum nach links verschoben ist bzw. versetzt ist. Er befindet sich somit in etwa genau über dem freien Abstandsbereich 22a der untersten Einzel-Isolierschicht 20a. Somit sind hier insgesamt drei Einzel-Isolierschichten 20a, 20b und 20c mit jeweils freien Abstandsbereichen 22a, 22b und 22c vorgesehen. Der Träger 13 weist also an seiner Außenseite 17 überall mindestens eine Einzel-Isolierschicht 20 auf, bis auf den Bereich rund um die Schweißnaht 18 sind es drei Einzel-Isolierschichten 20. Dies gilt auch für die Schweißnaht 18 direkt.

Auf die oberste Einzel-Isolierschicht 20c werden die vorgenannten Heizleiter, Kontaktfelder 27 und Leiterbahnen 28 aufgebracht wie üblich. Die Heizleiter und Leiterbahnen 28 werden wiederum mittels einer Schutzschicht 24, welche vorteilhaft eine glashaltige Schicht ist, auf übliche Art und Weise abgedeckt. Dabei bleiben die Kontaktfelder 27 frei zur Herstellung eines elektrischen Kontakts. Die Schutzschicht 24 weist ebenso einen freien Abstandsbereich 24' auf, der genau mit demjenigen freien Abstandsbereich 22b der Einzel-Isolierschicht 20b übereinstimmt. Er resultiert aus der Schwierigkeit beim vollständig umlaufenden Bedrucken, wie zuvor mehrfach erläutert worden ist. Durch diese Schutzschicht 24 wird, ähnlich wie eine weitere Einzel-Isolierschicht 20, eine ausreichende elektrische Isolierung auch im Bereich der freien Abstandsbereiche hin zur Anschlussvorrichtung erreicht.

Aus der auseinandergezogenen Darstellung der Fig. 4 ist zu ersehen, wie oberhalb des Trägers 13 mit Außenseite 17 und Schweißnaht 18 die drei Einzel-Isolierschichten 20a, 20b und 20c jeweils versetzt zueinander sind. Der Versatz ist so groß, dass sich die freien Abstandsbereiche zweier direkt aufeinanderfolgend aufgebrachter Isolierschichten 20 nicht überdecken bzw. zumindest einige Millimeter Überdeckung erreicht ist. Dass diese jeweils genau über die Schweißnaht 18 verläuft, kann vorteilhaft sein, um diese abzudecken, es muss aber nicht so sein.

Als oberste Schicht ist die Abdeckschicht 24 vorgesehen, wobei bei der Herstellung zwischen Aufbringung der Einzel-Isolierschicht 20c und der Schutzschicht 24 der funktionale Aufbau der Heizeinrichtung 11 auf die Einzel-Isolierschicht 20c in Form der Heizleiter, Kontaktfelder und Leiterbahnen aufgebracht wird.

Aus der vergrößerten Draufsicht der Fig. 5 ist zu ersehen, wie bei dem Träger 13 mit Außenseite 17 und Schweißnaht 18 unterschiedlich geformte Einzel-Isolierschichten 20a und 20b angeordnet sind. Der freie Abstandsbereich 22a der Einzel-Isolierschicht 20a ist nach rechts von der Schweißnaht 18 verschoben. Der freie Abstandsbereich 22b der Einzel-Isolierschicht 20b ist nach links von der Schweißnaht 18 verschoben. Die Enden der Einzel-Isolierschichten 20a und 20b überlappen sich hier einige Millimeter, und beide Endbereiche verlaufen oberhalb der Schweißnaht 18. Der Einfachheit halber sind hier nur zwei Einzel-Isolierschichten 20a und 20b vorgesehen. Dass deren Konturen unterschiedlich sind, spielt hier keine Rolle.

Aus der Fig. 5 ist auch zu ersehen, dass mit etwa gleichem seitlichem Abstand zur Schweißnaht 18 links zwei Kontaktfelder 27 mit Leiterbahnen 28 und rechts ein Kontaktfeld 27 mit einer Leiterbahn 28 vorgesehen ist. Dies bedeutet, dass die Anschlussvorrichtung 30 in etwa mittig oberhalb der Schweißnaht 18 angeordnet ist.

Dies ist aus der Fig. 6 mit der gesamten Isolierschicht 20 und der Schutzschicht 24 darauf zu ersehen. Unterhalb der Anschlussvorrichtung 30 ist der freie Abstandsbereich 22a der obersten Einzel-Isolierschicht der gesamten Isolierschicht 20 und ein freier Abstandsbereich 24' der Schutzschicht 24 zu erkennen. Die Einzel-Isolierschichten überlappen entsprechend Fig. 5 und sind einmal links und einmal rechts von der Schweißnaht 18 angeordnet. Bei der Schutzschicht 24 ist der freie Abstandsbereich 24' sozusagen offen bzw. nicht überdeckt. Hier liegt die Isolierschicht 20 darunter frei.

Seitlich unterhalb der Anschlussvorrichtung 30 stehen metallische Kontaktfüße 35 heraus. Der oberste linke Kontaktfuß 35 ist an die Außenseite 17 des Trägers 13 direkt angelötet oder angeschweißt. Der mit etwas Abstand darunter angeordnete Kontaktfuß 35 ist auf einem Kontaktfeld 27 samt Leiterbahn 28 angelötet, welches sich auf der oberen Einzel-Isolierschicht 20 befindet. Der wesentliche Bereich der Anschlussvorrichtung 11 ist hier mit der Schutzschicht 24 entsprechend der Fig. 4 überdeckt, wobei in dieser Schutzschicht 24 die Kontaktfelder 27 freigelassen sein sollten. Dafür weist die Schutzschicht 24 jeweils Fenster 29 für die Kontaktfelder 27 auf. Die Leiterbahnen 28 verlaufen unter der Schutzschicht 24 und außerhalb der Fenster 29, deswegen sind sie gestrichelt dargestellt.

Nach rechts stehen von der Anschlussvorrichtung 30 auch einige Kontaktfüße 35 ab, und diese sind innerhalb der Fenster 29 an Kontaktfelder 27 mit entsprechenden Leiterbahnen 28 angelötet. Aus der Draufsicht auf die Anschlussvorrichtung 30 ist zu erkennen, dass in deren Anschlussgehäuse 31 mehrere Steckfahnen 33 angeordnet sind. Jede dieser Steckfahnen 33 ist einstückig zusammenhängend mit einem Kontaktfuß 35 ausgebildet. Sie werden von unten her in das Anschlussgehäuse 31 eingesteckt, also von einer Unterseite 32 her.

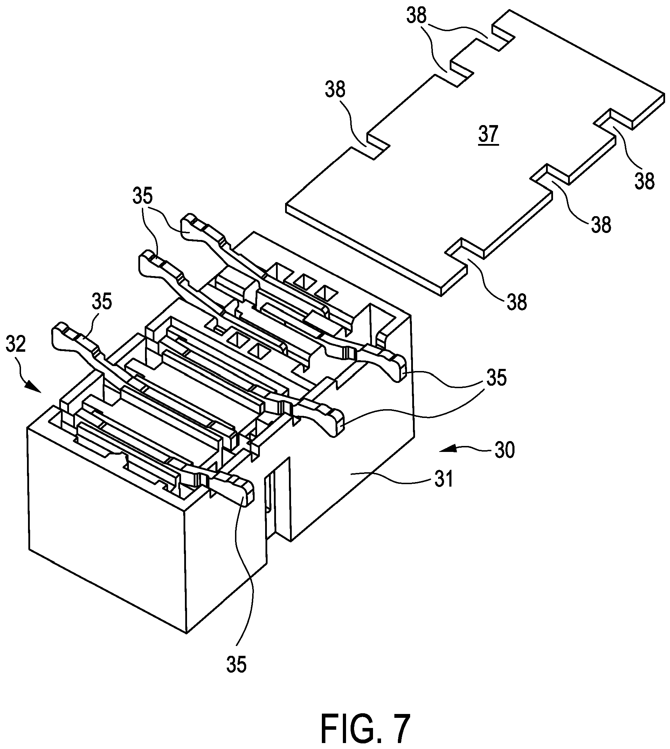

Diese Unterseite 32 des Anschlussgehäuses 31 der Anschlussvorrichtung 30 ist in der Fig. 7 dargestellt. Das Anschlussgehäuse 31 muss hier in gewisser Weise offen sein bzw. die Kontaktfüße 35 müssen offenliegen, ansonsten könnten sie nicht an dieser Unterseite 32 in das Anschlussgehäuse 31 eingesteckt und daran befestigt, verklemmt oder verrastet sein.

Eine weitere grundsätzliche Ausgestaltung der erfindungsgemäßen Zusatz-Isolierung ist hier in der Fig. 7 dargestellt. Dort ist ein rechts oberhalb davon dargestellter Unterseitendeckel 37 zu sehen, der an der Unterseite 32 befestigt werden kann. Der Unterseitendeckel 37 weist kleine Einschnitte 38 auf, damit hier die Kontaktfüße 35 hindurch verlaufen können. Eine Befestigung des Unterseitendeckels 37 an der Unterseite 32 des Anschlussgehäuses 31 kann entweder einfach durch Ankleben erfolgen, alternativ können vom Unterseitendeckel 37 nach unten Rastnasen oder andere ähnliche abstehende Teile vorstehen, die an der deutlich zu erkennenden komplexen Struktur der Unterseite 32 des Anschlussgehäuses 31 selbsttätig halten können. Durch die Ausgestaltung der Einschnitte 38 für die Kontaktfüße 35 kann auch vorgesehen sein, dass der Unterseitendeckel 37, der auch in der Fig. 2 dargestellt ist, mit relativ geringem Abstand zur Außenseite 17 des Trägers 13 verlaufen kann. Selbst wenn er sich von dem Anschlussgehäuse 31 lösen können sollte, so kann er aufgrund der formschlüssigen Halterung zwischen Kontaktfüßen 35 und Einschnitt 38 nicht verrutschen. So kann er in jedem Fall seine elektrische Isolierwirkung noch beibehalten.

## Patentansprüche

1. Heizeinrichtung (11) aufweisend:
- einen rohrförmigen Träger (13) mit einer Außenseite (17) und mit einer Innenseite (15),
- eine Isolierschicht (20) auf der Außenseite (17) des Trägers (13),
- Heizleiter, Leiterbahnen (28) und Kontaktfelder (27) auf der Isolierschicht (20),
- eine Anschlussvorrichtung (30) für einen elektrischen Anschluss der Heizeinrichtung (11),
wobei der Träger (13) eine Schweißnaht (18) oder Verbindungsnaht aufweist, die in seiner Längsrichtung und quer zum Umfangsrichtung verläuft,
**dadurch gekennzeichnet, dass**
- die Anschlussvorrichtung (30) mehrere metallische Kontaktfüße (35) aufweist,
- die Anschlussvorrichtung (30) mit den Kontaktfüßen (35) an den Kontaktfeldern (27) angeordnet oder befestigt und elektrisch verbunden ist,
- zwischen der Anschlussvorrichtung (30) und der Außenseite (17) des Trägers (13) eine elektrische Zusatz-Isolierung (20b, 20c, 25, 37) angeordnet ist,
- die Anschlussvorrichtung (30) über der Schweißnaht (18) und diese übergreifend mit Abstand dazu angeordnet ist.

2. Heizeinrichtung nach Anspruch 1, **dadurch gekennzeichnet, dass** die elektrische Zusatz-Isolierung (20b, 20c, 25, 37) fest mit dem Träger (13) verbunden ist oder fest an dem Träger (13) angeordnet ist.

3. Heizeinrichtung nach einem der vorhergehenden Ansprüche, **dadurch gekennzeichnet, dass** die Anschlussvorrichtung (30) über der Schweißnaht (18) und diese übergreifend mit Abstand von 0,3 mm bis 5 mm dazu angeordnet ist.

4. Heizeinrichtung nach Anspruch 3, **dadurch gekennzeichnet, dass** Heizleiter, Leiterbahnen (28) und Kontaktfelder (27) ausschließlich neben der Schweißnaht (18) oder Verbindungsnaht angeordnet sind, ohne diese zu überdecken, und vorzugsweise einen Abstand von mindestens 1 mm, insbesondere mindestens 5 mm, dazu aufweisen.

5. Heizeinrichtung nach einem der Ansprüche 2 bis 4, **dadurch gekennzeichnet, dass** die elektrische Zusatz-Isolierung (20b, 20c) ein Bereich der Isolierschicht (20) ist, wobei vorzugsweise die elektrische Isolierschicht (20) auf der Außenseite (17) des Trägers (13) mehrere Einzel-Isolierschichten (20a - 20c) aufweist und direkt zwischen Außenseite (17) des Trägers (13) und Anschlussvorrichtung (30) mindestens eine Einzel-Isolierschicht (20b, 20c) als elektrische Zusatz-Isolierung vorgesehen ist, wobei direkt zwischen Außenseite (17) des Trägers (13) und Anschlussvorrichtung (30) mindestens eine Einzel-Isolierschicht (20a - 20c) weniger vorgesehen ist als insgesamt Einzel-Isolierschichten (20a - 20c) aufeinander vorgesehen sind, vorzugsweise genau eine Einzel-Isolierschicht (20a - 20c) weniger vorgesehen ist als insgesamt Einzel-Isolierschichten (20a - 20c).

6. Heizeinrichtung nach Anspruch 5, **dadurch gekennzeichnet, dass** die Einzel-Isolierschichten (20a - 20c) nicht umlaufend geschlossen sind und jeweils an ihren entlang der Umfangsrichtung weisenden Enden bzw. dazwischen einen Abstand (22) zueinander aufweisen, insbesondere einen Abstand (22) zwischen 1 mm und 30 mm.

7. Heizeinrichtung nach Anspruch 6, **dadurch gekennzeichnet, dass** bei zwei direkt aufeinander liegenden Einzel-Isolierschichten (20a - 20c) deren in dieselbe Umfangsrichtung weisende Enden sich derart versetzt überlappen oder derart versetzt angeordnet sind, dass sich der Abstand (22a - 22c) zwischen den beiden Enden einer Einzel-Isolierschicht (20a - 20c) nicht mit dem Abstand (22a - 22c) zwischen den beiden Enden der anderen Isolierschicht (20) überlappen, wobei in Umfangsrichtung überall mindestens eine Einzel-Isolierschicht (20a - 20c) auf der Außenseite (17) des Trägers (13) vorgesehen ist.

8. Heizeinrichtung nach Anspruch 7, **dadurch gekennzeichnet, dass** drei direkt aufeinander liegende Einzel-Isolierschichten (20a - 20c) vorgesehen sind, wobei die beiden Enden der untersten Einzel-Isolierschicht (20a) unter den beiden Enden der obersten Einzel-Isolierschicht (20b, 20c) liegen bzw. sich die beiden Enden jeweils überdecken und auch die jeweiligen Abstände (22a - 22c) zwischen den beiden Enden sich jeweils überdecken, wobei die beiden Enden der dazwischenliegenden mittleren Einzel-Isolierschicht (20b) und der Abstand (22a - 22c) zwischen diesen beiden Enden von einem durchgehenden Bereich der untersten Einzel-Isolierschicht (20a) und einem durchgehenden Bereich der obersten Einzel-Isolierschicht (20c) überdeckt sind, wobei vorzugsweise die Außenseite (17) des Trägers (13) überall von einer, zwei oder von drei Einzel-Isolierschichten (20a - 20c) bedeckt ist.

9. Heizeinrichtung nach einem der Ansprüche 6 bis 8, **dadurch gekennzeichnet, dass** über der Schweißnaht (18) mindestens eine Einzel-Isolierschicht (20a - 20c) verläuft, vorzugsweise mindestens zwei Einzel-Isolierschichten (20a - 20c) und insbesondere eine Einzel-Isolierschicht (20) weniger als zwischen Außenseite (17) des Trägers (13) und Heizleiter.

10. Heizeinrichtung nach einem der Ansprüche 1 bis 4, **dadurch gekennzeichnet, dass** die elektrische Zusatz-Isolierung eine elektrisch isolierende Abdeckschicht (25) als Lack, Paste oder Kleber unterhalb der Anschlussvorrichtung (30) ist, wobei die Abdeckschicht (25) unterschiedlich von der Isolierschicht (20) ausgebildet ist, wobei insbesondere die Abdeckschicht (25) aufgebracht ist durch Sprühen, Dispensern, Drucken, Kleben odgl..

11. Heizeinrichtung nach Anspruch 10, **dadurch gekennzeichnet, dass** die Abdeckschicht (25) mindestens so groß ist wie die vertikale Projektion der Anschlussvorrichtung (30) auf den Träger (13), insbesondere zwischen 5% und 50% in einer Richtung oder in beiden Richtungen über diese überlappt.

12. Heizeinrichtung nach einem der Ansprüche 1 bis 4, **dadurch gekennzeichnet, dass** die elektrische Zusatz-Isolierung ein starres Isolationsteil (37) ist, das zwischen Außenseite (17) des Trägers (13) und der Anschlussvorrichtung (30) angeordnet ist, vorzugsweise befestigt ist, wobei insbesondere das Isolationsteil (37) an der Unterseite der Anschlussvorrichtung (30) befestigt ist und vorzugsweise nicht über die vertikale Projektion der Anschlussvorrichtung (30) auf den Träger (13) seitlich nach außen übersteht.

13. Heizeinrichtung nach einem der vorhergehenden Ansprüche, **dadurch gekennzeichnet, dass** die metallischen Kontaktfüße (35) im Bereich der Unterseite der Anschlussvorrichtung (30) von dieser seitlich abstehen, wobei die elektrische Isolierung zwischen den Kontaktfüßen (35) und der Außenseite (17) des Trägers (13) angeordnet ist, wobei vorzugsweise die Außenseite (17) hier ohne Isolierschicht (20) ausgebildet ist.

14. Heizeinrichtung nach einem der vorhergehenden Ansprüche, **dadurch gekennzeichnet, dass** die Isolierschicht (20) oder die Einzel-Isolierschichten (20a - 20c) mittels eines Dickschicht-Verfahrens auf die Außenseite (17) des Trägers (13) oder auf darunterliegende Einzel-Isolierschichten (20a - 20c) aufgebracht sind, insbesondere mittels Siebdruck.

15. Verfahren zur Herstellung einer Heizeinrichtung (11) nach einem der vorhergehenden Ansprüche, **dadurch gekennzeichnet, dass** auf dem Träger (13) mehrere Einzel-Isolierschichten (20a - 20c) aufgebracht werden, um die Isolierschicht (20) zu bilden, wobei die elektrische Zusatz-Isolierung zwischen Anschlussvorrichtung (30) und Außenseite (17) des Trägers (13) gebildet wird durch eine weitere Einzel-Isolierschicht (20a - 20c) oder durch eine Abdeckschicht (25) oder durch ein starres Isolationsteil (37).

## Claims

1. Heating device (11) comprising:
- a tubular carrier (13) with an outer side (17) and an inner side (15),
- an insulating layer (20) on the outer side (17) of the carrier (13),
- heating conductors, conductor tracks (28), and contact pads (27) on the insulating layer (20),
- a connection device (30) for an electrical connection of the heating device (11),
wherein the carrier (13) has a weld seam (18) or connecting seam which runs in its longitudinal direction and transversely to the circumferential direction,
**characterized in that**
- the connection device (30) has several metallic contact feet (35),
- the connection device (30) with the contact feet (35) is arranged or fastened to the contact pads (27) and is electrically connected,
- an additional electrical insulation (20b, 20c, 25, 37) is arranged between the connection device (30) and the outer side (17) of the carrier (13),
- the connection device (30) is arranged above the weld seam (18) and overlapping it at a distance therefrom.

2. Heating device according to claim 1, **characterized in that** the additional electrical insulation (20b, 20c, 25, 37) is firmly connected to the carrier (13) or is firmly arranged on the carrier (13).

3. Heating device according to one of the preceding claims, **characterized in that** the connection device (30) is arranged above the weld seam (18) and overlapping it at a distance of 0.3 mm to 5 mm therefrom.

4. Heating device according to claim 3, **characterized in that** heating conductors, conductor tracks (28) and contact pads (27) are arranged exclusively next to the weld seam (18) or connecting seam without covering it, and preferably have a distance of at least 1 mm, in particular at least 5 mm, from it.

5. Heating device according to one of claims 2 to 4, **characterized in that** the additional electrical insulation (20b, 20c) is a region of the insulating layer (20), wherein the electrical insulating layer (20) on the outer side (17) of the carrier (13) has several individual insulating layers (20a - 20c) and at least one individual insulating layer (20b, 20c) is provided directly between the outer side (17) of the carrier (13) and the connection device (30), whereby at least one single insulating layer (20a - 20c) less is provided directly between the outer side (17) of the carrier (13) and the connection device (30) than the total number of single insulating layers (20a - 20c) are provided on top of each other, preferably exactly one single insulating layer (20a - 20c) less is provided than the total number of single insulating layers (20a - 20c).

6. Heating device according to claim 5, **characterized in that** the individual insulating layers (20a - 20c) are not closed around their circumference and each have a distance (22) between them at their ends pointing in the circumferential direction or between them, in particular a distance (22) between 1 mm and 30 mm.

7. Heating device according to claim 6, **characterized in that**, in the case of two individual insulating layers (20a-20c) lying directly on top of each other, their ends pointing in the same circumferential direction overlap in a staggered manner or are arranged in a staggered manner such that the distance (22a - 22c) between the two ends of a single insulating layer (20a - 20c) does not coincide with the distance (22a - 22c) between the two ends of the other insulating layer (20), wherein at least one individual insulating layer (20a - 20c) is provided everywhere in the circumferential direction on the outer side (17) of the carrier (13).

8. Heating device according to claim 7, **characterized in that** three individual insulating layers (20a - 20c) lying directly on top of each other are provided, wherein the two ends of the lowest individual insulating layer (20a) lie below the two ends of the uppermost individual insulating layer (20b, 20c), or the two ends overlap each other and the respective distances (22a - 22c) between the two ends also overlap each other, wherein the two ends of the middle individual insulating layer (20b) located between them and the distance (22a - 22c) between these two ends are covered by a continuous area of the lowest individual insulating layer (20a) and a continuous area of the uppermost individual insulating layer (20c), whereby preferably the outer side (17) of the carrier (13) is covered everywhere by one, two, or three individual insulating layers (20a - 20c).

9. Heating device according to one of claims 6 to 8, **characterized in that** at least one individual insulating layer (20a - 20c) extends over the weld seam (18), preferably at least two individual insulating layers (20a - 20c) and, in particular, one individual insulating layer (20) less than between the outer side (17) of the carrier (13) and the heating conductor.

10. Heating device according to one of claims 1 to 4, **characterized in that** the additional electrical insulation comprises an electrically insulating covering layer (25) in the form of paint, paste, or adhesive below the connection device (30), wherein the covering layer (25) is designed differently from the insulating layer (20), wherein, in particular, the covering layer (25) is applied by spraying, dispensing, printing, gluing, or the like.

11. Heating device according to claim 10, **characterized in that** the covering layer (25) is at least as large as the vertical projection of the connection device (30) onto the carrier (13), in particular overlaps between 5% and 50% in one direction or in both directions.

12. Heating device according to one of claims 1 to 4, **characterized in that** the additional electrical insulation is a rigid insulation part (37) which is arranged between the outer side (17) of the carrier (13) and the connection device (30), preferably fastened, wherein in particular the insulation part (37) is fastened to the underside of the connection device (30) and preferably does not protrude laterally outward beyond the vertical projection of the connection device (30) onto the carrier (13).

13. Heating device according to one of the preceding claims, **characterized in that** the metallic contact feet (35) protrude laterally from the connection device (30) in the area of the underside of the connection device (30), wherein the electrical insulation between the contact feet (35) and the outer side (17) of the carrier (13), the outer side (17) preferably being designed without an insulating layer (20) in this case.

14. Heating device according to one of the preceding claims, **characterized in that** the insulating layer (20) or the individual insulating layers (20a - 20c) are applied to the outer side (17) of the carrier (13) or to underlying individual insulating layers (20a - 20c) by means of a thick-film process, in particular by means of screen printing.

15. Method for manufacturing a heating device (11) according to one of the preceding claims, **characterized in that** several individual insulating layers (20a - 20c) are applied to the carrier (13) in order to form the insulating layer (20), wherein the additional electrical insulation between the connection device (30) and the outer side (17) of the carrier (13) is formed by a further individual insulating layer (20a - 20c) or by a covering layer (25) or by a rigid insulating part (37).

## Revendications

1. Dispositif de chauffage (11) comprenant :
- un support tubulaire (13) avec une face extérieure (17) et une face intérieure (15),
- une couche isolante (20) sur la face extérieure (17) du support (13),
- des conducteurs chauffants, des pistes conductrices (28) et des zones de contact (27) sur la couche isolante (20),
- un dispositif de raccordement (30) pour le raccordement électrique du dispositif de chauffage (11),
le support (13) comportant un cordon de soudure (18) ou un cordon de liaison qui s'étend dans sa direction longitudinale et transversalement à la direction circonférentielle,
**caractérisé en ce que**
- le dispositif de raccordement (30) comporte plusieurs pieds de contact métalliques (35),
- le dispositif de raccordement (30) avec les pieds de contact (35) est disposé ou fixé sur les zones de contact (27) et est relié électriquement,
- une isolation électrique supplémentaire (20b, 20c, 25, 37) est disposée entre le dispositif de raccordement (30) et la face extérieure (17) du support (13),
- le dispositif de raccordement (30) est disposé au-dessus de la soudure (18) et recouvre celle-ci à distance de celle-ci.

2. Dispositif de chauffage selon la revendication 1, **caractérisé en ce que** l'isolation électrique supplémentaire (20b, 20c, 25, 37) est reliée de manière fixe au support (13) ou est disposée de manière fixe sur le support (13).

3. Dispositif de chauffage selon l'une des revendications précédentes, **caractérisé en ce que** le dispositif de raccordement (30) est disposé au-dessus du cordon de soudure (18) et le recouvre à une distance comprise entre 0,3 mm et 5 mm.

4. Dispositif de chauffage selon la revendication 3, **caractérisé en ce que** les conducteurs chauffants, les pistes conductrices (28) et les zones de contact (27) sont disposés exclusivement à côté du cordon de soudure (18) ou du cordon de liaison, sans les recouvrir, et présentent de préférence un écart d'au moins 1 mm, en particulier d'au moins 5 mm, par rapport à ceux-ci.

5. Dispositif de chauffage selon l'une des revendications 2 à 4, **caractérisé en ce que** l'isolation électrique supplémentaire (20b, 20c) est une partie de la couche isolante (20), la couche isolante électrique (20) comporte plusieurs couches isolantes individuelles (20a à 20c) sur la face extérieure (17) du support (13) et qu'au moins une couche isolante individuelle (20b, 20c) est prévue comme isolation électrique supplémentaire directement entre la face extérieure (17) du support (13) et le dispositif de raccordement (30) (20b, 20c) est prévue directement entre la face extérieure (17) du support (13) et le dispositif de raccordement (30) en tant qu'isolation électrique supplémentaire, au moins une couche isolante individuelle (20a - 20c) de moins que le nombre total de couches isolantes individuelles (20a - 20c) prévues les unes sur les autres, de préférence exactement une couche isolante individuelle (20a - 20c) de moins que le nombre total de couches isolantes individuelles (20a - 20c).

6. Dispositif de chauffage selon la revendication 5, **caractérisé en ce que** les couches isolantes individuelles (20a - 20c) ne sont pas fermées sur tout leur pourtour et présentent chacune, à leurs extrémités orientées dans le sens périphérique ou entre celles-ci, un écart (22) les unes par rapport aux autres, en particulier un écart (22) compris entre 1 mm et 30 mm.

7. Dispositif de chauffage selon la revendication 6, **caractérisé en ce que**, dans le cas de deux couches isolantes individuelles (20a - 20c) superposées, leurs extrémités orientées dans la même direction circonférentielle se chevauchent de manière décalée ou sont disposées de manière décalée de telle sorte que l'écart (22a - 22c) entre les deux extrémités d'une couche isolante individuelle (20a - 20c) ne coïncide pas avec l'écart (22a - 22c) entre les deux extrémités de l'autre couche isolante (20), au moins une couche isolante individuelle (20a - 20c) étant prévue partout dans la direction circonférentielle sur la face extérieure (17) du support (13).

8. Dispositif de chauffage selon la revendication 7, **caractérisé en ce que** trois couches isolantes individuelles (20a à 20c) superposées sont prévues, les deux extrémités de la couche isolante individuelle la plus basse (20a) se trouvant sous les deux extrémités de la couche isolante individuelle la plus haute (20b, 20c), les deux extrémités se recouvrant respectivement et les écarts respectives (22a - 22c) entre les deux extrémités se recouvrant également respectivement, les deux extrémités de la couche isolante individuelle centrale (20b) située entre celles-ci et l'écart (22a - 22c) entre ces deux extrémités sont recouvertes par une zone continue de la couche isolante individuelle la plus basse (20a) et une zone continue de la couche isolante individuelle supérieure (20c), la face extérieure (17) du support (13) étant de préférence recouverte partout par une, deux ou trois couches isolantes individuelles (20a - 20c).

9. Dispositif de chauffage selon l'une des revendications 6 à 8, **caractérisé en ce qu'**au moins une couche isolante individuelle (20a à 20c) s'étend au-dessus du cordon de soudure (18), de préférence au moins deux couches isolantes individuelles (20a à 20c) et en particulier une couche isolante individuelle (20) de moins qu'entre la face extérieure (17) du support (13) et le conducteur chauffant.

10. Dispositif de chauffage selon l'une des revendications 1 à 4, **caractérisé en ce que** l'isolation électrique supplémentaire comprend une couche de recouvrement électriquement isolante (25) sous forme de vernis, pâte ou colle sous le dispositif de raccordement (30), la couche de recouvrement (25) étant différente de la couche isolante (20), la couche de recouvrement (25) étant notamment appliquée par pulvérisation, distribution, impression, collage ou similaire.

11. Dispositif de chauffage selon la revendication 10, **caractérisé en ce que** la couche de recouvrement (25) est au moins aussi grande que la projection verticale du dispositif de raccordement (30) sur le support (13), en particulier entre 5 % et 50 % dans une direction ou dans les deux directions, et la recouvre.

12. Dispositif de chauffage selon l'une des revendications 1 à 4, **caractérisé en ce que** l'isolation électrique supplémentaire est une pièce d'isolation rigide (37) qui est disposée entre la face extérieure (17) du support (13) et le dispositif de raccordement (30), de préférence fixée, la pièce d'isolation (37) est fixée sur la face inférieure du dispositif de raccordement (30) et ne dépasse de préférence pas latéralement vers l'extérieur au-delà de la projection verticale du dispositif de raccordement (30) sur le support (13).

13. Dispositif de chauffage selon l'une des revendications précédentes, **caractérisé en ce que** les pieds de contact métalliques (35) dépassent latéralement de la face inférieure du dispositif de raccordement (30) dans la zone de celle-ci, l'isolation électrique étant assurée entre les pieds de contact (35) et la face extérieure (17) du support (13), la face extérieure (17) étant de préférence réalisée ici sans couche isolante (20).

14. Dispositif de chauffage selon l'une des revendications précédentes, **caractérisé en ce que** la couche isolante (20) ou les couches isolantes individuelles (20a à 20c) sont appliquées sur la face extérieure (17) du support (13) ou sur les couches isolantes individuelles (20a à 20c) situées en dessous au moyen d'un procédé à couche épaisse, en particulier au moyen d'une sérigraphie.

15. Procédé de fabrication d'un dispositif de chauffage (11) selon l'une des revendications précédentes, **caractérisé en ce que** plusieurs couches isolantes individuelles (20a - 20c) sont appliquées sur le support (13) afin de former la couche isolante (20), l'isolation électrique supplémentaire entre le dispositif de raccordement (30) et la face extérieure (17) du support (13) étant formée par une autre couche isolante individuelle (20a - 20c) ou par une couche de recouvrement (25) ou par une pièce d'isolation rigide (37).
